# EUROPÄISCHE PATENTSCHRIFT

(11) **EP 2 751 491 B1**
(45) Veröffentlichungstag und Bekanntmachung des Hinweises auf die Patenterteilung: **21.04.2021**
(21) Anmeldenummer: 12758812.7
(22) Anmeldetag: 27.08.2012
(51) Int. Cl.: F24C 15/10, F24C 7/08, H03K 17/96

(54) **HAUSHALTSGERÄT UND VERFAHREN ZUM BETREIBEN EINES SOLCHEN HAUSHALTSGERÄTS**
HOUSEHOLD APPLIANCE AND METHOD FOR OPERATING SUCH A HOUSEHOLD APPLIANCE
APPAREIL MÉNAGER ET PROCÉDÉ D'UTILISATION D'UN TEL APPAREIL MÉNAGER

(30) Priorität: 30.08.2011 DE 102011081769
(43) Veröffentlichungstag der Anmeldung: 09.07.2014
(73) Patentinhaber: BSH Hausgeräte GmbH, 81739 München (DE)
(72) Erfinder: KOJER, Mario, 83342 Tacherting (DE); MAIER, Thomas, 84518 Garching a.d. Alz (DE); MARBACH, Andreas, 83374 Traunwalchen (DE)
(74) Vertreter: Lang, Michael
(86) Internationale Anmeldenummer: PCT/EP2012/066588
(87) Internationale Veröffentlichungsnummer: WO 2013/030145

(56) Entgegenhaltungen:
- EP-A1- 1 691 486
- EP-A1- 2 107 855
- EP-A2- 1 598 599
- WO-A1-2005/073633
- WO-A1-2006/135152
- DE-U1- 9 407 567
- US-A- 5 138 137
- DATABASE WPI Week 200101 Thomson Scientific, London, GB; AN 2001-005272 XP002686471, & KR 2000 0013141 A (SAMSUNG ELECTRONICS CO LTD) 6. März 2000 (2000-03-06)

## Beschreibung

Die Erfindung betrifft ein Haushaltsgerät mit mindestens einem Bedienelement in Form einer Sensortaste, zum Einstellen mindestens eines Einstellparameters des Haushaltsgeräts, wobei das Haushaltsgerät dazu eingerichtet ist, eine Fehlbetätigung des Bedienelements zu erkennen. Die Erfindung betrifft ferner ein Verfahren zum Betreiben eines Haushaltsgeräts, bei dem eine Fehlbetätigung des Bedienelements erkannt wird.

Es sind Kochgeräte mit einem typischerweise mehrere Kochstellen aufweisenden Kochfeld bekannt, welche eine Fehlbetätigung aufgrund einer einen vorbestimmten Schwellwert überschreitenden Betätigungsdauer ("Dauerbetätigung") erkennen. Als Reaktion auf eine solche Dauerbetätigung wird das Kochfeld mit sämtlichen Kochstellen abgeschaltet. Möchte ein Bediener nach dem Abschalten des Kochfelds und nach einer Beseitigung der Ursache für die Dauerbetätigung einen vor dem Abschalten vorhandenen Betriebszustand des Kochfelds wiederherstellen, muss er zumeist die Einstellung manuell ändern.

Es ist die **Aufgabe** der vorliegenden Erfindung, die Nachteile des Standes der Technik zumindest teilweise zu überwinden und insbesondere eine bedienerfreundlichere Reaktion auf eine Fehlbetätigung eines Kochfelds bereitzustellen.

Diese Aufgabe wird gemäß den Merkmalen der unabhängigen Ansprüche gelöst. Bevorzugte Ausführungsformen sind insbesondere den abhängigen Ansprüchen entnehmbar.

Die Aufgabe wird gelöst durch ein Haushaltsgerät mit mindestens einem Bedienelemen in Form einer Sensortaste zum Einstellen oder Verstellen mindestens eines Einstellparameters des Haushaltsgeräts, wobei das Haushaltsgerät dazu eingerichtet ist, eine Fehlbetätigung des Bedienelements zu erkennen. Die Fehlbetätigung wird aufgrund ihrer Dauerbetätigung erkannt, wobei eine Dauerbetätigung durch Erreichen oder Überschreiten eines ersten Schwellwerts einer Betätigungsdauer festgestellt wird.

Das Haushaltsgerät ist ferner dazu eingerichtet, mindestens einen dem fehlbetätigten Bedienelement zugeordneten Einstellparameter automatisch auf einen unmittelbar vor der Fehlbetätigung gültigen Wert zurückzusetzen.

Dies ergibt den Vorteil, dass durch die Fehlbetätigung ausgelöste Aktionen praktisch nicht umgesetzt werden und die vorher gültigen Einstellungen bzw. Einstellparameter eines durch das fehlbetätigte Bedienelement einstellbaren Funktionselements nicht verloren gehen. So kann ein normaler Betrieb des Funktionselements (insbesondere einschließlich einer Anzeige des Einstellparameters) nach Beseitigung der Ursache der Fehlbetätigung vereinfacht wiederhergestellt werden. Es wird insbesondere ermöglicht, dass Funktionselemente, deren Bedienelemente nicht fehlbetätigt werden, ohne Änderungen oder nur mit Änderungen einer Anzeige, weiter betreibbar sind, was unnötige Unterbrechungen dieser Funktionselemente verhindert. So ergibt sich eine erhöhte Bedienerfreundlichkeit.

Das Bedienelement ist eine Sensortaste eines berührungsempfindlichen Bedienfelds, da es bei solchen Bedienfeldern häufiger zu Fehlbetätigungen kommen kann, z.B. durch ein Verschütten oder Überlaufen von elektrisch leitfähiger Flüssigkeit (z.B. Suppe, Soße, Nudelwasser usw.) über kapazitiv schaltende Sensortasten usw. Das berührungsempfindliche Bedienfeld mag ein reines Bedienfeld ("Touchfeld") oder ein berührungsempfindlicher Bildschirm ("Touchscreen") sein. Im Fall eines berührungsempfindlichen Bildschirms kann eine Sensortaste einem Bildschirmbereich entsprechen und mag umkonfigurierbar sein.

Unter einer Fehlbetätigung kann insbesondere eine ungewollte Betätigung des Bedienelements verstanden werden, welche nicht durch eine Berührung eines Bedieners erfolgt, sondern z.B. auch durch ein Verschütten oder Überkochen von Suppe oder Wasser, ein Ablegen von Gegenständen auf dem Bedienelement usw. verursacht sein kann.

Erfindungsgemäß ist das Haushaltsgerät dazu eingerichtet die Fehlbetätigung mit einem Erreichen oder Überschreiten eines (ersten) Schwellwerts einer Betätigungsdauer ("Dauerbetätigung") festzustellen. Dabei wird angenommen, dass ein Bediener üblicherweise keinen Grund hat, ein Bedienelement sehr lange zu betätigen und es auch nicht gewohnt ist. Eine solche Fehlbetätigung ist einfach und zuverlässig erkennbar und ermöglicht eine praktisch effektive Trennung von regulären (gewollten) Betätigungen und klaren Fehlbetätigungen.

Es ist möglich, dass der erste Schwellwert signifikant größer ist als eine längste Zeitdauer einer regulären Betätigung des Bedienelements. So kann eine reguläre Betätigung des Bedienelements von einer Fehlbetätigung sicherer unterschieden werden. Das Bedienelement kann beispielsweise eine Wiederholfunktion ("Repeat-Funktion") aufweisen, bei welcher bei einer längeren Betätigung ein zugehöriger Einstellparameter wiederholt verstellt wird, z.B. erhöht oder erniedrigt wird. Eine längste Zeitdauer einer regulären Betätigung mag beispielsweise diejenige Zeitdauer sein, welche benötigt wird, um einen Parameterbereich des Einstellparameters ganz zu durchlaufen, ggf. zuzüglich einer Zeitdauer, welche ein Bediener typischerweise benötigt, um das Ende der Einstellung festzustellen und um eine Berührung zu beenden.

Es ist noch eine Ausgestaltung der Erfindung, dass das Haushaltsgerät dazu eingerichtet ist, eine dem fehlbetätigten Bedienelement zugehörige Funktionseinheit des Haushaltsgeräts mit dem Zurücksetzen aktiviert zu halten. Folglich wird ein Betrieb des Funktionselements aufgrund der Fehlbetätigung nicht oder nicht wesentlich verändert, was besonders bedienerfreundlich ist.

Es ist eine weitere Ausgestaltung der Erfindung, dass das Haushaltsgerät dazu eingerichtet ist, eine dem fehlbetätigten Bedienelement zugehörige Funktionseinheit des Haushaltsgeräts mit dem Zurücksetzen zu deaktivieren. Dabei bleibt aber der zurückgesetzte oder zurückgestellte Einstellparameter erhalten (und beispielsweise auch in einer Anzeige sichtbar) und braucht von einem Bediener nicht neu eingestellt zu werden. Bei dieser Ausgestaltung wird eine Sicherheit des Funktionselements erhöht, z.B. vor einer ungewolltem Betrieb, und folglich auch eine Bediensicherheit.

Es ist noch eine weitere Ausgestaltung der Erfindung, dass das Haushaltsgerät dazu eingerichtet ist, die dem fehlbetätigten Bedienelement zugehörige Funktionseinheit des Haushaltsgeräts mit einer Beseitigung der Fehlbetätigung automatisch wieder zu aktivieren. Dies ermöglicht eine besonders einfache Wiederaufnahme eines Betriebs des Funktionselements in einem Zustand vor der Fehlbetätigung.

Es ist auch eine Ausgestaltung der Erfindung, dass das Haushaltsgerät dazu eingerichtet ist, die dem fehlbetätigten Bedienelement zugehörige Funktionseinheit des Haushaltsgeräts mit einer Beseitigung der Fehlbetätigung und einer folgenden Quittierung wieder zu aktivieren. Die Quittierung ermöglicht eine noch weiter erhöhte Betriebssicherheit, da einer Aktivierung der Funktionseinheit eine bewusste Aktion des Bedieners zwischengeschaltet ist. Dadurch wird z.B. verhindert, dass die Funktionseinheit wieder aktiviert wird, wenn sich die Ursache für die Fehlbetätigung selbstständig beseitigt, z.B. durch ein Verdampfen von auf dem Bedienfeld ausgeschüttetem Wasser usw.

Es ist auch eine Ausgestaltung der Erfindung, dass das Haushaltsgerät dazu eingerichtet ist, mit einem Erreichen oder Überschreiten eines zweiten Schwellwerts der Betätigungsdauer, welcher größer ist als der erste Schwellwert, das Haushaltsgerät sicherheitsabzuschalten. Dadurch wird eine sehr lange Dauerbetätigung erkannt und ausgenutzt, dass sogar diese sehr lange Dauerbetätigung bisher nicht von einem Bediener erkannt worden ist (ggf. trotz einer Ausgabe von Warnhinweisen) und der Bediener sich also wahrscheinlich nicht in der Nähe des Haushaltsgeräts befindet. Die Sicherheitsabschaltung des gesamten Haushaltsgeräts erhöht also eine Betriebssicherheit für den Fall einer Abwesenheit eines Bedieners. So können auch länger dauernde Vorgänge, aufgrund derer sich die Ursache für die Fehlbetätigung selbstständig beseitigt, berücksichtigt werden.

Dieser zweite Schwellwert kann insbesondere um ein Vielfaches größer sein als der erste Schwellwert, z.B. zehnmal größer. Es wird bevorzugt, dass der zweite Schwellwert eine Größenordnung von Minuten aufweist, z.B. von zwei Minuten.

Es ist ferner eine Ausgestaltung der Erfindung, dass die Fehlbetätigung eine gleichzeitige Betätigung mehrerer Bedienelemente umfasst und das Haushaltsgerät dazu eingerichtet ist, bei der gleichzeitigen Betätigung keinen zu den mehreren Bedienelementen zugehörigen Einstellparameter zu verstellen. Eine Fehlbetätigung kann in dieser Ausgestaltung also schon dadurch erkannt werden, dass mehrere Bedienelemente gleichzeitig betätigt werden. Nach einem zusätzlichen Feststellen einer Dauerbetätigung werden die Einstellparameter "zurückgesetzt". Da die Einstellparameter jedoch gar nicht erst verstellt wurden, ändert die Zurücksetzung der Einstellparameter keine Werte, ggf. wird aber mindestens ein Hinweis ausgegeben.

Es ist darüber hinaus eine Ausgestaltung der Erfindung, dass das Haushaltsgerät dazu eingerichtet ist, mit Erkennen der Fehlbetätigung mindestens einen Hinweis an einen Bediener auszugeben. Dieser mag den Bediener insbesondere auf ein Vorliegen einer Dauerbetätigung hinweisen. Diese Ausgestaltung ist besonders bedienerfreundlich, da sie dem Bediener unmittelbar einen Hinweis auf die Fehlbetätigung geben kann.

Der mindestens eine Hinweis kann einen akustischen Hinweis (z.B. ein leises oder lautes Piepen) und/oder einen optischen Hinweis (z.B. ein Blinken einer oder mehrerer Anzeigen oder Anzeigefelder) umfassen.

Es ist darüber hinaus eine Ausgestaltung der Erfindung, dass das Haushaltsgerät dazu eingerichtet ist, die Ausgabe des mindestens einen Hinweises mit einer Beseitigung der Fehlbetätigung zu deaktivieren. So kann besonders einfach ein normaler Betrieb wiederhergestellt werden, insbesondere wenn das Funktionselement aktiviert geblieben ist oder sich ebenfalls mit der Beseitigung der Fehlbetätigung selbsttätig aktiviert.

Es ist eine alternative Ausgestaltung der Erfindung, dass das Haushaltsgerät dazu eingerichtet ist, die Ausgabe des Hinweises mit einer Beseitigung der Fehlbetätigung und einer folgenden Quittierung zu deaktivieren. So kann zur Herstellung eines normalen Betriebs eine Interaktion mit einem Bediener verlangt werden, was eine Betriebssicherheit erhöht. Diese Ausgestaltung kann sowohl gewählt werden, wenn das Funktionselement mit der Zurücksetzung aktiv bleibt (ein Bediener erkennt die Fehlbetätigung also nur über das Vorliegen des mindestens einen Hinweises), als auch wenn das Funktionselement mit der Zurücksetzung deaktiviert worden ist.

Es ist noch möglich, dass ein Hauptschalter des Haushaltsgeräts bei einer Erkennung einer Dauerbetätigung ein Kochfeld sicherheitsabschaltet, also alle Kochstellen ausschaltet. Während der Sicherheitsabschaltung können entsprechende Hinweise ausgegeben werden. Es wird für eine erhöhte Betriebssicherheit bevorzugt, dass mit Erkennen einer Fehlbetätigung des Hauptschalters Einstellparameter des Haushaltsgeräts nicht automatisch zurückgesetzt oder zurückgestellt werden. So kann verhindert werden, dass sich das gesamte Kochfeld unbemerkt oder ungewollt wieder einschaltet.

Es ist noch eine Ausgestaltung der Erfindung, dass das Haushaltsgerät ein Kochgerät mit einem mindestens eine Kochstelle aufweisenden Kochfeld ist, z.B. ein Herd, ein Kochfeldaufsatz oder ein alleinstehendes ("Stand-Alone"-)Kochfeld. Solche Kochgeräte weisen häufig in das Kochfeld integrierte Sensortasten auf, die aufgrund ihrer oberseitigen Lage besonders anfällig gegenüber einer Fehlbetätigung sind.

Es wird ferner bevorzugt, dass der mindestens eine Einstellparameter eine Kochstufe umfasst. Die Kochstufe ist der für einen Bediener typischerweise primär genutzte Einstellparameter und ist zudem besonders sicherheitsrelevant, z.B. in Bezug auf einen ungewollten Betrieb.

Eine nicht erfindungsgemäße Ausbildung mag umfassen, dass eine Kochstelle als dem Funktionselement auf einer bestimmten Kochstufe KS>0 als dem Einstellparameter steht. Ein zugehöriges Bedienelement ist mit einer Wiederholfunktion ausgestattet und erhöht die Kochstufe. Die Kochstufe wird in einem entsprechenden Anzeigenfeld angezeigt. Mit einer längeren Betätigung dieses Bedienelements wird die Kochstufe solange hochgestellt (bis zu einem maximalen Wert), bis eine Fehlbetätigung in Form einer Dauerbetätigung erkannt wird. Folgend wird die Kochstufe KS auf ihren vor der Dauerbetätigung gültigen Wert zurückgestellt (und eine erneute Verstellung durch die Wiederholfunktion bis zur Beseitigung der Dauerbetätigung unterbunden). Dabei bleibt die Kochstelle aktiv und heizt. Die Anzeige der Kochstufe bleibt erhalten, wobei sie jedoch nun zusammen mit allen anderen aktiven Anzeigen blinkt, während sie in einem normalen Betrieb (vor der Fehlbetätigung) statisch (nicht-blinkend) ist. Zudem ertönt ein Piepsen. Mit Beseitigung einer Ursache der Dauerbetätigung bleibt die Kochstelle unverändert aktiv, die Anzeige(n) geben sich wieder statisch und das Piepsen hört auf.

Diese nicht erfindungsgemäße Ausbildung mag auch umfassen, dass eine Kochstelle auf einer bestimmten Kochstufe KS>0 steht. Die Kochstufe wird in einem entsprechenden Anzeigenfeld angezeigt. Mit einer gleichzeitigen Betätigung des zugehörigen Bedienelements und mindestens eines weiteren Bedienelements wird eine Fehlbetätigung erkannt, aber nicht darauf reagiert. So werden weder eine Kochstufe noch eine Anzeige verändert. Mit Erkennen einer Dauerbetätigung der durch mehrfache Betätigung erzeugten Fehlbetätigung bleibt die Kochstufe bestehen und die Kochstelle aktiv. Zur Ausgabe eines Hinweises an den Bediener blinken alle aktiven Anzeigen, und es ertönt ein Piepsen. Mit Beseitigung der Ursache der Dauerbetätigung bleibt die Kochstelle unverändert aktiv, die Anzeige(n) geben sich wieder statisch und das Piepsen hört auf.

Diese nicht erfindungsgemäße Ausbildung mag zudem umfassen, dass eine Kochstelle auf einer bestimmten Kochstufe KS>0 steht. Ein zugehöriges Bedienelement ist mit einer Wiederholfunktion ausgestattet und erniedrigt die Kochstufe. Die Kochstufe wird in einem entsprechenden Anzeigenfeld angezeigt. Mit einer längeren Betätigung dieses Bedienelements wird die Kochstufe solange erniedrigt (bis zu einem minimalen Wert, welcher einer ausgeschalteter Kochstelle entspricht), bis eine Fehlbetätigung in Form einer Dauerbetätigung erkannt wird. Befindet sich die Kochstufe KS bei "0", d.h., dass die zugehörige Kochstelle ausgeschaltet ist, wird die Kochstufe KS nicht auf ihren vor der Dauerbetätigung gültigen Wert zurückgestellt. Die Kochstelle bleibt also ausgeschaltet. Die Anzeige der Kochstufe ("0") bleibt erhalten, wobei sie jedoch nun zusammen mit allen anderen aktiven Anzeigen blinkt. Zudem ertönt ein Piepsen. Mit Beseitigung einer Ursache der Dauerbetätigung bleibt die Kochstelle unverändert ausgeschaltet, und die Anzeige(n) zeigen statisch eine Restwärme (z.B. symbolisiert durch den kleinen Buchstaben "h") an. Das Piepsen hört auf.

In den folgenden Figuren wird die Erfindung anhand von Ausführungsbeispielen schematisch genauer beschrieben. Dabei können zur Übersichtlichkeit gleiche oder gleichwirkende Elemente mit gleichen Bezugszeichen versehen sein.
- Fig.1: zeigt als Schnittdarstellung in Seitenansicht ein Kochgerät mit Kochfeldern und einer Steuereinheit, wobei in der Steuereinheit ein erster Teil eines Ablaufdiagramms zum Betreiben des Kochgeräts eingezeichnet ist; und
- Fig.2: zeigt einen zweiten Teil des Ablaufdiagramms.

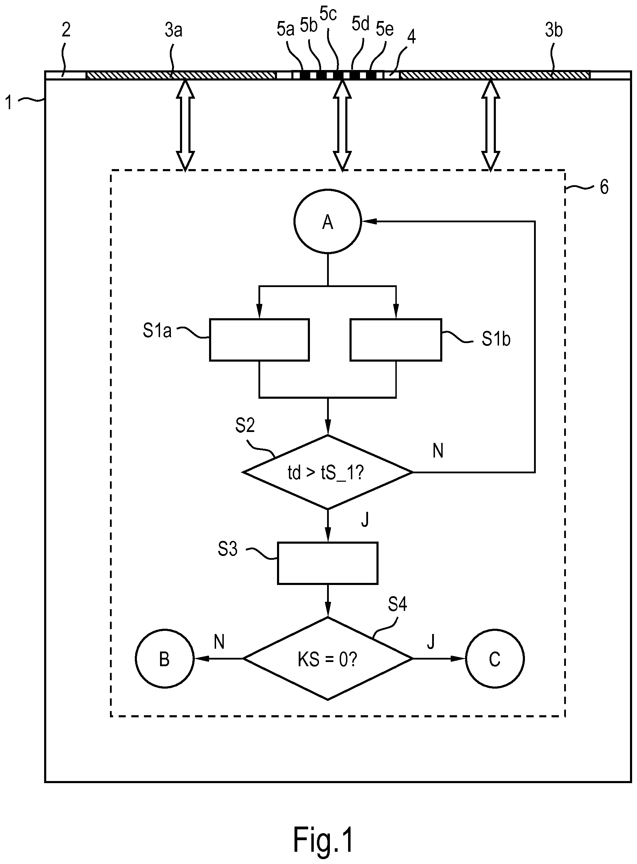

**Fig.1** zeigt ein Haushaltsgerät in Form eines Kochgeräts 1. Das Kochgerät 1 ist hier als ein Herd mit einem oberseitig angeordneten Kochfeld 2 ausgestaltet. Das Kochfeld 2 weist mehrere Kochstellen 3a, 3b und ein zur Bedienung der Kochstellen 3a, 3b vorgesehenes Bedienfeld 4 auf. Das Bedienfeld 4 ist als ein Sensorfeld ("Touchfeld") mit mehreren berührempfindlichen (Sensor-)Tasten 5a-e als Bedienelementen ausgestattet. Mittels der Tasten 5a-e kann ein Benutzer mindestens einen Einstellparameter der Kochstellen 3a, 3b einstellen, beispielsweise eine zugehörige Kochstufe KS oder einen sog. Timer. Das Bedienfeld 4 stellt ferner mindestens eine Anzeigeeinheit (o.Abb.) bereit, beispielsweise um über die Tasten 5a-e vorgenommene Einstellungen anzuzeigen. Die mindestens eine Anzeigeneinheit mag dazu beispielsweise kochstellenspezifische und allgemeine Segmentanzeigen aufweisen.

Beispielsweise mag ein Benutzer eine Kochstufe KS der Kochstelle 3a mittels der Taste 5a erhöhen und mittels der Taste 5b erniedrigen. Analog mag ein Benutzer eine Kochstufe KS der Kochstelle 3b mittels der Taste 5d erhöhen und mittels der Taste 5e erniedrigen. Die Kochsteufen mögen beispielsweise zwischen KS = "0" (ausgeschaltete Kochstelle) und KS = "9" (maximale Leistung) einstellbar sein, ggf. mit Zwischenstufen.

Das Bedienfeld 4 ist mit einer Steuereinrichtung 6 gekoppelt, wie durch den dazwischen positionierten mittigen Pfeil angedeutet. Die Steuereinrichtung 6 ist in der Lage, Signale der Tasten 5a-e zu empfangen, auszuwerten und für eine Ansteuerung der Kochstellen 3a, 3b zu verwenden, wie durch die beiden äußeren Pfeile angedeutet. Insbesondere ist die Steuereinrichtung 6 dazu eingerichtet, den in ihr eingezeichneten Verfahrensablauf auszuführen, der im Folgenden genauer erläutert wird.

Der Verfahrensablauf wird beispielhaft anhand der Kochstelle 3a erläutert. Zu Beginn des Verfahrensablaufs bei einem Ausgangspunkt "A" ist die Kochstelle 3a mit einer vorbestimmten Kochstufe, z.B. mit der Kochstufe KS = "7", aktiviert.

Folgend kann sich eine Fehlbetätigung an dem Bedienfeld 4 ergeben, z.B. durch ein Bedecken des Bedienfelds 4 mit einem elektrisch leitfähigen Material, (z.B. Suppe oder Nudelwasser im Fall eines kapazitiven Bedienfelds), durch ein Abstellen eines Gegenstands oder durch ein unbeabsichtigtes Auflehnen eines Bedieners auf das Bedienfeld 4 usw.

Dabei können in einem auf den Ausgangspunkt "A" folgenden Schritt S1a mehrere der Tasten 5a-e gleichzeitig (fehl)betätigt werden, so dass sie ein jeweiliges Signal an die Steuereinrichtung 6 ausgeben. Die Steuereinrichtung 6 erkennt bereits aus dem gleichzeitigen Signaleingang mehrerer Tasten 5a-e eine Fehlbetätigung und verändert die Kochstufe KS der Kochstelle 3a nicht.

Alternativ mag in einem auf den Ausgangspunkt "A" folgenden Schritt S1b nur eine Taste, hier beispielhaft die Taste 5a zum Erhöhen der Kochstufe KS der Kochstelle 3a oder die Taste 5b zum Erniedrigen der Kochstufe KS, betätigt werden. Das Kochgerät 1 kann eine reguläre Betätigung der Taste 5a oder 5b von ihrer Fehlbetätigung zunächst nicht ohne weiteres unterscheiden und erhöht bzw. erniedrigt die Kochstufe KS deshalb. Die Taste 5a arbeitet hier mit einer Wiederholfunktion zusammen, d.h., dass bei einer länger anhaltenden Betätigung die Kochstufen KS wiederholt hochgeschaltet werden, z.B. von "7" auf "9", den maximalen Wert. Auch die Taste 5a arbeitet mit einer Wiederholfunktion zusammen, d.h., dass bei einer länger anhaltenden Betätigung die Kochstufen KS wiederholt heruntergeschaltet werden, z.B. von "7" auf "3" oder auf "0", den minimalen Wert.

In einem Schritt S2 wird abgefragt, ob eine Zeitdauer td der Betätigung der Tasten 5a-e in Schritt S1a bzw. der Taste 5a oder 5b in Schritt S1b einen ersten Schwellwert tS_1 überschritten hat, d.h., ob die Relation td > tS_1 eingetreten ist. Ist dies nicht der Fall ("N"), wurde die Betätigung also vorher aufgehoben, wird zum Ausgangspunkt A zurückgekehrt, und zwar bei zuvorigem Durchlaufen von Schritt S1a unter Annahme einer regulären Betätigung unter Beibehaltung der erhöhten bzw. der erniedrigten Kochstufe KS.

Ist die Zeitdauer td jedoch größer als der Schwellwert tS_1 (Zweig "J" in Schritt S2), wird in einem Schritt S3 eine Fehlbetätigung erkannt. Der Schwellwert tS_1 ist dazu größer gewählt als die maximale Zeit, die bei einer regulären Dauerbetätigung zum Durchlaufen eines Bereichs eines Einstellparameters, welcher durch eine mit einer Wiederholfunktion gekoppelten Taste 5a-e verstellbar ist, benötigt wird, z.B. zum Hochschalten einer Kochstufe von dem Wert KS = "0" zu dem Wert KS = "9", oder umgekehrt zum Herunterschalten. Der erste Schwellwert tS_1 beträgt z.B. ca. 5 Sekunden.

Nach dem Erkennen der Fehlbetätigung in Schritt S3 wird in einem Schritt S4 abgefragt, ob ein durch die Fehlbetätigung eingestellter Endwert des Einstellparameters, hier der Kochstufe KS, einem Ausschaltzustand, hier der Kochstufe KS = "0", entspricht. Ist die Taste 5a betätigt worden, ist dies nicht der Fall ("N"). Ist die Taste 5b betätigt worden, ist dies jedoch der Fall ("J").

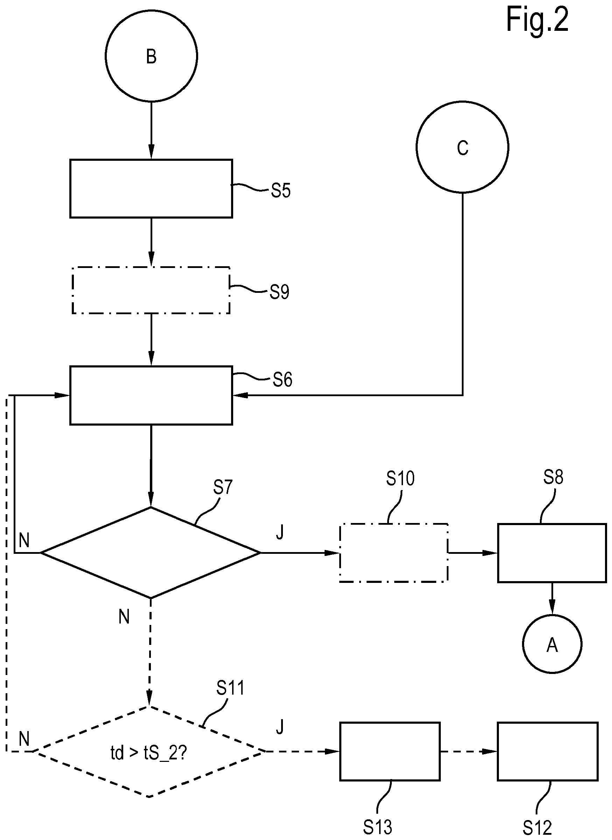

**Fig.2** zeigt einen zweiten Teil des Ablaufdiagramms, welcher an die Zweige "N" und "J" von Schritt S4 anschließt.

Zunächst wird der Fall "N" beschrieben, also der Fall für eine Kochstufe KS > 0 bei Erkennen der Fehlbetätigung mit Erreichen des ersten Schwellwerts tS_1. Hierbei wird in einem Schritt S5 durch die Steuereinrichtung 6 die Kochstufe KS (z.B. "9" im Fall von Schritt S1b oder "7" im Fall von Schritt S1a) automatisch oder selbsttätig auf den Wert KS = "7" zurückgesetzt, welcher vor der Fehlbetätigung in Schritt S1a, S1b eingestellt oder gültig war. Im Fall von Schritt S1a beinhaltet das Zurücksetzen ein Beibehalten der in Schritt S1a nicht verstellten Kochstufe KS = "7".

Mit (d.h., vor, während oder nach) dem Zurücksetzen in Schritt S5 kann die Steuereinheit 6 in Schritt S6 anweisen, mindestens einen Hinweis an einen Bediener auszugeben, um auf die Fehlbetätigung hinzuweisen. Der mindestens eine Hinweis kann beispielsweise eine Ausgabe eines Signaltons (z.B. eines "Piepens") und/oder eine Ausgabe eines optischen Signals (z.B. eines Blinkens einer die Kochstufe KS der Kochstelle 3a anzeigenden Anzeige oder eines Blinkens aller aktiven Anzeigen des Kochgeräts 1) umfassen. Dieser Zustand wird beendet, falls in Schritt S7 die Fehlbetätigung beseitigt wird ("J") und bleibt ansonsten bestehen ("N"). Die Fehlbetätigung kann beispielsweise durch ein Trockenwischen verschütteter Flüssigkeit usw. beseitigt oder aufgehoben werden.

Mit Beseitigung der Fehlbetätigung wird in dem gezeigten Ausführungsbeispiel in Schritt S8 die Ausgabe der Hinweise gestoppt und zurück zu Ausgangspunkt A gelaufen, ggf. nach einer Bestätigung oder Quittierung durch den Benutzer. Bei diesem Verfahrensablauf bleibt die Kochstelle 3a durchgehend aktiviert (falls die Kochstufe KS vor der Fehlbetätigung nicht auf "0" stand), so dass durch die Fehlbetätigung ein Kochvorgang nicht unterbrochen wird.

In einer optionalen Variante mag, wie durch den optionalen Schritt S9 angedeutet (welcher mit Schritt S5 erfolgen kann), zusätzlich zu einem Zurücksetzen der Kochstufe KS auf den unmittelbar vor der Fehlbetätigung vorliegenden Wert die zugehörige Kochstelle 3a deaktiviert werden, d.h., dass diese nicht bestromt wird. In diesem Fall ist also die Einstellung der Kochstufe KS zurückgesetzt worden (und damit z.B. auch in einer zu der Kochstelle 3a zugehörigen Anzeige sichtbar), das zugehörige Funktionselement aber deaktiviert. So kann eine Gefahr eines ungewollten Betriebs reduziert werden. Zudem kann diese Kochstelle 3a so nach der Beseitigung der Fehlbetätigung ("J" in Schritt S7) einfach wieder aktiviert werden (Schritt S10), ohne dass ein Bediener den Einstellparameter zuvor neu einstellen muss. Die erneute Aktivierung in Schritt S10 kann automatisch durch die Steuereinrichtung 6 oder nach einer Bestätigung oder Quittierung durch den Benutzer erfolgen.

In noch einer optionalen Variante kann mit der negativen Abfrage ("N") in Schritt S7, ob die Fehlbetätigung beseitigt ist, abgefragt werden, ob die Zeitdauer td der Fehlbetätigung größer (oder gleich) einem zweiten Schwellwert tS_2 ist (Schritt S11). Der zweite Schwellwert tS_2 ist größer als der erste Schwellwert tS_1, z.B. ca. 2 Minuten. Mit Überschreiten des zweiten Schwellwerts tS_2 ("J") wird das Kochgerät 1 sicherheitsabgeschaltet (Schritt S12), was hier bedeutet, dass sämtliche Kochstellen 3a, 3b abgeschaltet oder deaktiviert werden. Dies kann mit einer Ausgabe mindestens eines entsprechenden Hinweises (Schritt S13) an einen Bediener einhergehen. Durch das Sicherheitsabschalten wird ein ungewollter Betrieb an den Kochstellen 3a, 3b für den Fall verhindert, dass eine Fehlbetätigung für eine längere Zeit trotz der in Schritt S6 ausgegeben Hinweise nicht beseitigt wird und sich folglich ein Bediener wahrscheinlich nicht in der näheren Umgebung des Kochgeräts 1 befindet, um ggf. lenkend eingreifen zu können.

Nun wird der Fall "J" aus Schritt S4 beschrieben, also, der Fall für eine Kochstufe KS = 0 (ausgeschaltete Kochstelle) bei Erkennen der Fehlbetätigung mit Erreichen des ersten Schwellwerts tS_1. Hierbei wird auf die Schritte S5, S6 und die optionalen Schritte S9, S10 verzichtet und direkt zu Schritt S6, dem Ausgeben mindestens eines Hinweises, gesprungen. Es wird hier also nicht auf den vor der Fehlbetätigung gültigen Wert der Kochstufe KS zurückgestellt oder zurückgesetzt. Dadurch wird sichergestellt, dass kein unbeabsichtigtes Aktivieren der ausgeschalteten Kochstelle 3a auftritt, z.B. für den Fall, dass die Fehlbetätigung und damit das Ausschalten beobachtet und akzeptiert wird.

Selbstverständlich ist die vorliegende Erfindung nicht auf die gezeigten Ausführungsbeispiele beschränkt.

### Bezuaszeichenliste

- 1: Kochgerät
- 2: Kochfeld
- 3a: Kochstelle
- 3b: Kochstelle
- 4: Bedienfeld
- 5a-e: Taste
- 6: Steuereinrichtung
- A: Ausgangspunkt
- KS: Kochstufe
- td: Zeitdauer
- tS_1: erster Schwellwert
- tS_2: zweiter Schwellwert
- S1-S13: Verfahrensschritte 1 bis 13

## Patentansprüche

1. Haushaltsgerät (1) mit mindestens einer Sensortaste (5a-e) eines berührungsempfindlichen Bedienfelds zum Einstellen mindestens eines Einstellparameters (KS) des Haushaltsgeräts (1), wobei das Haushaltsgerät (1) dazu eingerichtet ist, eine Fehlbetätigung der Sensortaste (5a-e) aufgrund ihrer Dauerbetätigung zu erkennen (S3), wobei das Haushaltsgerät (1) dazu eingerichtet ist,
- die Fehlbetätigung in Form der Dauerbetätigung durch ein Erreichen oder Überschreiten eines ersten Schwellwerts (tS_1) einer Betätigungsdauer (td) festzustellen (S2, S3),
**dadurch gekennzeichnet, dass** das Haushaltsgerät (1) weiterhin dazu eingerichtet ist,
- mindestens einen durch die so fehlbetätigte Sensortaste (5a-e) verstellten Einstellparameter (KS) automatisch auf einen unmittelbar vor der Fehlbetätigung gültigen Wert zurückzusetzen (S5).

2. Haushaltsgerät (1) nach Anspruch 1, **dadurch gekennzeichnet, dass** das Haushaltsgerät (1) dazu eingerichtet ist, eine der fehlbetätigten Sensortaste (5a-e) zugehörige Funktionseinheit (3a, 3b) des Haushaltsgeräts (1) mit dem Zurücksetzen aktiviert zu halten.

3. Haushaltsgerät (1) nach Anspruch 1, **dadurch gekennzeichnet, dass** das Haushaltsgerät (1) dazu eingerichtet ist, eine der fehlbetätigten Sensortaste (5a-e) zugehörige Funktionseinheit (3a, 3b) des Haushaltsgeräts (1) mit dem Zurücksetzen zu deaktivieren (S9).

4. Haushaltsgerät (1) nach Anspruch 3, **dadurch gekennzeichnet, dass** das Haushaltsgerät (1) dazu eingerichtet ist, die der fehlbetätigten Sensortaste (5a-e) zugehörige Funktionseinheit (3a, 3b) des Haushaltsgeräts (1) mit der Beseitigung der Fehlbetätigung wieder zu aktivieren (S10).

5. Haushaltsgerät (1) nach Anspruch 3, **dadurch gekennzeichnet, dass** das Haushaltsgerät (1) dazu eingerichtet ist, die der fehlbetätigten Sensortaste (5a-e) zugehörige Funktionseinheit (3a, 3b) des Haushaltsgeräts (1) mit der Beseitigung der Fehlbetätigung und einer folgenden Quittierung wieder zu aktivieren (S10).

6. Haushaltsgerät (1) nach einem der vorhergehenden Ansprüche, **dadurch gekennzeichnet, dass** das Haushaltsgerät (1) dazu eingerichtet ist, mit einem Erreichen oder Überschreiten eines zweiten Schwellwerts (tS_2) der Betätigungsdauer (S11), welcher größer ist als der erste Schwellwert (tS_1), das Haushaltsgerät (1) sicherheitsabzuschalten (S12).

7. Haushaltsgerät (1) nach einem der vorhergehenden Ansprüche, **dadurch gekennzeichnet, dass** eine weitere Fehlbetätigung eine gleichzeitige Betätigung mehrerer Sensortasten (5a-e) umfasst (S1a) und das Haushaltsgerät (1) dazu eingerichtet ist, bei der gleichzeitigen Betätigung keinen zu den mehreren Sensortasten (5a-e) zugehörigen Einstellparameter zu verstellen.

8. Haushaltsgerät (1) nach einem der vorhergehenden Ansprüche, **dadurch gekennzeichnet, dass** das Haushaltsgerät (1) dazu eingerichtet ist, mit Erkennen der Fehlbetätigung (S3) mindestens einen Hinweis an einen Bediener auszugeben (S6).

9. Haushaltsgerät (1) nach Anspruch 8, **dadurch gekennzeichnet, dass** das Haushaltsgerät (1) dazu eingerichtet ist, die Ausgabe des Hinweises mit einer Beseitigung der Fehlbetätigung zu deaktivieren.

10. Haushaltsgerät (1) nach Anspruch 9, **dadurch gekennzeichnet, dass** das Haushaltsgerät (1) dazu eingerichtet ist, die Ausgabe des Hinweises mit einer Beseitigung der Fehlbetätigung und einer folgenden Quittierung zu deaktivieren (S8).

11. Haushaltsgerät (1) nach einem der vorhergehenden Ansprüche, **dadurch gekennzeichnet, dass** das Haushaltsgerät (1) ein Kochgerät ist, die mindestens eine Sensortaste (5a-5e) eine Sensortaste (5a-5e) eines berührungsempfindlichen Bedienfelds des Kochfelds ist und der mindestens eine durch die mindestens eine Sensortaste (5a-5e) einstellbare Einstellparameter eine Kochstufe (KS) umfasst.

12. Verfahren zum Betreiben eines Haushaltsgeräts (1) gemäß einem der vorhergehenden Ansprüche 1-11, bei dem
- eine Dauerbetätigung einer Sensortaste (5a-e) eines berührungsempfindlichen Bedienfelds aufgrund eines Erreichens oder Überschreitens eines ersten Schwellwerts (tS_1) seiner Betätigungsdauer (td) erkannt wird (S2, S3), welche Dauerbetätigung durch ein Erreichen oder Überschreiten eines ersten Schwellwerts (tS_1) einer Betätigungsdauer (td) feststellbar ist (S2, S3) und
- mindestens ein durch die so fehlbetätigte Sensortaste (5a-e) verstellter Einstellparameter (KS) automatisch auf einen unmittelbar vor der Fehlbetätigung gültigen Wert zurückgesetzt wird (S5).

## Claims

1. Household appliance (1) with at least one touch key (5a-e) of a touch-sensitive control panel for setting at least one setting parameter (KS) of the household appliance (1), wherein the household appliance (1) is designed to identify (S3) faulty operation of the touch key (5a-e) on account of its continuous operation, wherein the household appliance (1) is designed
- to determine (S2, S3) the faulty operation in the form of permanent operation by reaching or exceeding a first threshold value (tS_1) of an operation period (td),
**characterised in that**
the household appliance (1) is further designed
- to automatically reset (S5) at least one setting parameter (KS), adjusted by the touch key (5a-e) thus operated in a faulty manner, to a value which is valid immediately before the faulty operation.

2. Household appliance (1) according to claim 1, **characterised in that** the household appliance (1) is designed to keep a functional unit (3a, 3b) of the household appliance (1), associated with the touch key (5a-e) operated in a faulty manner, active with the reset.

3. Household appliance (1) according to claim 1, **characterised in that** the household appliance (1) is designed to deactivate (S9) a functional unit (3a, 3b) of the household appliance (1), associated with the touch key (5a-e) operated in a faulty manner, with the reset.

4. Household appliance (1) according to claim 3, **characterised in that** the household appliance (1) is designed to reactivate (S10) the functional unit (3a, 3b) of the household appliance (1), associated with the touch key (5a-e) operated in a faulty manner, by eliminating the faulty operation.

5. Household appliance (1) according to claim 3, **characterised in that** the household appliance (1) is designed to reactivate (S10) the functional unit (3a, 3b) of the household appliance (1), associated with the touch key (5a-e) operated in a faulty manner, by eliminating the faulty operation and a subsequent acknowledgement.

6. Household appliance (1) according to one of the preceding claims, **characterised in that** the household appliance (1) is designed to safely switch off (S12) the household appliance (1) when a second threshold value (tS_2) of the operation period (S11), which is greater than the first threshold value (tS_1), is reached or exceeded.

7. Household appliance (1) according to one of the preceding claims, **characterised in that** a further faulty operation comprises (S1a) simultaneous operation of a number of touch keys (5a-e) and the household appliance (1) is designed, with simultaneous operation, not to adjust any setting parameters associated with the number of touch keys (5a-e).

8. Household appliance (1) according to one of the preceding claims, **characterised in that** the household appliance (1) is designed to output (S6) at least one notification to an operator upon recognition of a faulty operation (S3).

9. Household appliance (1) according to claim 8, **characterised in that** the household appliance (1) is designed to deactivate the output of the notification by eliminating the faulty operation.

10. Household appliance (1) according to claim 9, **characterised in that** the household appliance (1) is designed to deactivate (S8) the output of the notification by eliminating the faulty operation and a subsequent acknowledgement.

11. Household appliance (1) according to one of the preceding claims, **characterised in that** the household appliance (1) is a cooking appliance, the at least one touch key (5a-5e) is a touch key (5a-5e) of a touch-sensitive control panel of the hob, and the at least one setting parameter which can be set by the at least one touch key (5a-5e) comprises a heat setting (KS).

12. Method for operating a household appliance (1) according to one of the preceding claims 1-11, in which
- a permanent operation of a touch key (5a-e) of a touch-sensitive control panel is identified (S2, S3) on account of a first threshold value (tS_1) of its operation period (td) being reached or exceeded, which continuous operation can be determined by a first threshold value (tS_1) of an operation period (td) being reached or exceeded and
- at least one setting parameter (KS) adjusted by the touch key (5a-e) thus operated in a faulty manner is reset (S5) automatically to a value which is valid immediately before the faulty operation.

## Revendications

1. Appareil électroménager (1) avec au moins une touche à effleurement (5a-e) d'un panneau de commande sensible au toucher destiné au réglage d'au moins un paramètre de réglage (KS) de l'appareil électroménager (1), dans lequel l'appareil électroménager (1) est conçu pour reconnaître (S3) un actionnement défaillant de la touche à effleurement (5a-e) en raison de son actionnement en continu, dans lequel l'appareil électroménager (1) est conçu pour
- constater (S2, S3) l'actionnement défaillant sous la forme de l'actionnement en continu en atteignant ou en dépassant une première valeur de seuil (tS_1) d'une durée d'actionnement (td),
**caractérisé en ce que** l'appareil électroménager (1) est en outre conçu pour
- réinitialiser (S5) automatiquement au moins un paramètre de réglage (KS) ajusté par le biais de la touche à effleurement (5a-e) ainsi actionnée de manière défaillante à une valeur valide directement antérieure à l'actionnement défaillant.

2. Appareil électroménager (1) selon la revendication 1, **caractérisé en ce que** l'appareil électroménager (1) est conçu pour maintenir activée avec la réinitialisation une unité de fonctionnement (3a, 3b) de l'appareil électroménager (1) associé à la touche à effleurement (5a-e) activée de manière défaillante.

3. Appareil électroménager (1) selon la revendication 1, **caractérisé en ce que** l'appareil électroménager (1) est conçu pour désactiver (S9) avec la réinitialisation une unité de fonctionnement (3a, 3b) de l'appareil électroménager (1) associé à la touche à effleurement (5a-e) activée de manière défaillante.

4. Appareil électroménager (1) selon la revendication 3, **caractérisé en ce que** l'appareil électroménager (1) est conçu pour réactiver (S10) avec la suppression de l'actionnement défaillant l'unité de fonctionnement (3a, 3b) de l'appareil électroménager (1) associé à la touche à effleurement (5a-e) activée de manière défaillante.

5. Appareil électroménager (1) selon la revendication 3, **caractérisé en ce que** l'appareil électroménager (1) est conçu pour réactiver (S10) avec la suppression de l'actionnement défaillant et une confirmation consécutive l'unité de fonctionnement (3a, 3b) de l'appareil électroménager (1) associé à la touche à effleurement (5a-e) activée de manière défaillante.

6. Appareil électroménager (1) selon l'une des revendications précédentes, **caractérisé en ce que** l'appareil électroménager (1) est conçu pour éteindre par sécurité (S12) l'appareil électroménager (1) en atteignant ou en dépassant une seconde valeur de seuil (tS_2) de la durée d'actionnement (S11) qui est supérieure à la première valeur de seuil (tS_1).

7. Appareil électroménager (1) selon l'une des revendications précédentes, **caractérisé en ce qu'**un actionnement défaillant supplémentaire comprend (S1a) un actionnement simultané de plusieurs touches à effleurement (5a-e) et l'appareil électroménager (1) est conçu pour n'ajuster aucun paramètre de réglage associé aux plusieurs touches de capteur (5a-e) lors de l'actionnement simultané.

8. Appareil électroménager (1) selon l'une des revendications précédentes, **caractérisé en ce que** l'appareil électroménager (1) est conçu pour délivrer (S6) au moins une indication à un utilisateur avec la reconnaissance de l'actionnement défaillant (S3).

9. Appareil électroménager (1) selon la revendication 8, **caractérisé en ce que** l'appareil électroménager (1) est conçu pour désactiver la délivrance de l'indication avec une suppression de l'actionnement défaillant.

10. Appareil électroménager (1) selon la revendication 9, **caractérisé en ce que** l'appareil électroménager (1) est conçu pour désactiver (S8) la délivrance de l'indication avec une suppression de l'actionnement défaillant et une confirmation consécutive.

11. Appareil électroménager (1) selon l'une des revendications précédentes, **caractérisé en ce que** l'appareil électroménager (1) est un appareil de cuisson, l'au moins une touche à effleurement (5a-5e) est une touche à effleurement (5a-5e) d'un panneau de commande sensible au toucher de la table de cuisson et l'au moins un paramètre de réglage réglable par le biais de l'au moins une touche à effleurement (5a-5e) comprend une étape de cuisson (KS).

12. Procédé destiné au fonctionnement d'un appareil électroménager (1) selon l'une des revendications 1 à 11 précédentes, dans lequel
- un actionnement en continu d'une touche à effleurement (5a-e) d'un panneau de commande sensible au toucher est reconnu (S2, S3) en raison d'une atteinte ou d'un dépassement d'une première valeur de seuil (tS_1) de sa durée d'actionnement (td), lequel actionnement sur la durée peut être constaté (S2, S3) par le biais d'une atteinte ou d'un dépassement d'une première valeur de seuil (tS_1) d'une durée d'actionnement (td) et
- au moins un paramètre de réglage (KS) ajusté par le biais de la touche à effleurement (5a-e) ainsi actionnée de manière défaillante est réinitialisé (S5) automatiquement à une valeur valide directement antérieure à l'actionnement défaillant.
